# EUROPÄISCHE PATENTSCHRIFT

(11) **EP 1 770 793 B1**
(45) Veröffentlichungstag und Bekanntmachung des Hinweises auf die Patenterteilung: **03.11.2010**
(21) Anmeldenummer: 06018039.5
(22) Anmeldetag: 29.08.2006
(51) Int. Cl.: H01L 33/00, F21S 8/10

(54) **Elektromagnetische Strahlung emittierendes optoelektronisches Bauelement und Verfahren zum Herstellen eines Bauelements**
Optoelectronic device emitting electromagnetic radiation and method for manufacturing said device
Dispositif optoélectronique émettant de rayonnement electromagnetique et procédé pour la fabrication d'un tel dispositif

(30) Priorität: 13.12.2005 DE 102005059524; 30.09.2005 DE 102005047153
(43) Veröffentlichungstag der Anmeldung: 04.04.2007
(73) Patentinhaber: OSRAM Opto Semiconductors GmbH, 93055 Regensburg (DE)
(72) Erfinder: Schwenkschuster, Lukas, 71576 Burgstetten (DE); Wüller, Martin, 48231 Warendorf (DE); Reill, Joachim, 93197 Zeitlarn (DE); Engl, Moritz, 93055 Regensburg (DE)
(74) Vertreter: Epping - Hermann - Fischer

(56) Entgegenhaltungen:
- EP-A- 1 526 328
- WO-A-2004/066409
- DE-A1- 10 059 498
- JP-A- 11 340 515
- JP-A- 2002 094 127
- JP-A- 2002 289 926
- US-A- 3 780 357
- US-A1- 2004 061 433

## Beschreibung

Elektromagnetische Strahlung emittierendes optoelektrisches Bauelement und Verfahren zum Herstellen eines Bauelements.

Diese Patentanmeldung beansprucht die Priorität der deutschen Patentanmeldungen 102005059524.3 und 102005047153.6.

Die Erfindung betrifft ein elektromagnetische Strahlung emittierendes Bauelement mit einem Gehäuse sowie ein Verfahren zum Herstellen eines Bauelements.

Es sind Gehäuse für elektromagnetische Strahlung emittierende optoelektronische Bauelemente mit einem Grundkörper bekannt, der eine Ausnehmung definiert. Der Boden dieser Ausnehmung ist für eine Montage eines Lumineszenzdiodenchips vorgesehen. Die Innenwände der Ausnehmung können in der Art eines Reflektors geformt sein, sodass ein Teil einer von dem Lumineszenzdiodenchip emittierten elektromagnetische Strahlung mittels der Innenwände in einen gewünschten Abstrahl-Raumwinkel umgelenkt werden kann. Ein Beispiel für ein Bauelement mit einem derartigen Gehäuse ist in der US 5,040,868 offenbart.

Optoelektronische Bauelemente, die eine elektromagnetische Strahlung emittieren, finden immer häufiger in Scheinwerfer- oder Projektionsapplikationen Anwendung. Ein Beispiel für einen Scheinwerfer, in dem elektromagnetische Strahlung emittierende Lumineszenzdioden verwendet werden, ist in der DE 10315131 Al angegeben. Es handelt sich hierbei um einen Scheinwerfer für Fahrzeuge, bei dem eine Mehrzahl von Lumineszenzdiodenchips in einer gemeinsamen Ausnehmung angeordnet sind. Die Ausnehmung weist auf einer in Lichtabstrahlrichtung gewandten Seite eine Randkante auf, die derart in räumlicher Anordnung zu den Lumineszenzdiodenchips steht, dass im Bereich der Randkanten ein vorgegebener Leuchtdichtegradient für eine Lichtverteilung des Scheinwerfers ausgebildet wird.

Bei solchen Scheinwerferapplikationen ist es wichtig, eine von Lumineszenzdiodenchips emittierte elektromagnetische Strahlung mit einer möglichst hohen Strahlungsdichte mit einer vorgegebenen Strahlungsverteilung in einen vorgegebenen, engen Raumwinkel abzustrahlen. Dazu werden zum Beispiel Strahlenkegel mittels Optiken wie Projektionslinsen auf eine gewünschte Ebene projiziert. Bei derartigen Anwendungen können Unregelmäßigkeiten in der Abstrahlcharakteristik verwendeter optoelektronischer Bauelemente verstärkt werden und somit besonders störend wirken. Von daher gibt es einen Bedarf an Bauelementen, die hinsichtlich ihrer Abstrahleigenschaften speziell für derartige Anwendungen ausgebildet sind.

US 3 780 357 offenbart ein optoelektronisches Bauelement, bei dem ganzflächis eine Abschirmschicht auf einer Außfläche aufgebracht ist.

Eine zu lösende Aufgabe besteht darin, ein Gehäuse der eingangs genannten Art anzugeben, das durch technisch einfache Maßnahmen bezüglich erzielbarer Abstrahlcharakteristiken gegenüber bekannten Gehäusen verbessert ist. Das Gehäuse soll insbesondere besser für Scheinwerferapplikationen geeignet sein. Zudem soll ein Bauelement mit einem derartigen Gehäuse und ein Verfahren zum Herstellen eines derartigen Gehäuses angegeben werden.

Die erfinderische Lösung wird durch die Ansprüche 1 und 19 definiert.

Es wird ein Gehäuse der eingangs genannten Art angegeben, bei dem eine Außenfläche, die auf einer Abstrahlseite des Gehäuses angeordnet ist, zumindest teilweise mit einer Abschirmschicht versehen ist. Die Abschirmschicht ist geeignet, eine elektromagnetische Strahlung abzuschirmen, wobei insbesondere vorgesehen ist, eine im Inneren des Gehäuses erzeugte oder zu erzeugende elektromagnetische Strahlung nach außen abzuschirmen. Dadurch kann bei entsprechenden optoelektronischen Bauelementen mit einem derartigen Gehäuse vorteilhafterweise ein Austritt elektromagnetischer Strahlung aus dem Gehäuse in unerwünschte Raumwinkel deutlich verringert oder vollständig vermieden werden.

Das Gehäuse weist bevorzugt einen Gehäusegrundkörper mit einer Ausnehmung auf, in der eine Chipanschlussfläche angeordnet ist, wobei die Außenfläche, die mit der Abschirmschicht versehen ist, an die Ausnehmung angrenzt.

Bei herkömmlichen elektromagnetische Strahlung emittierenden Bauelementen wurde festgestellt, dass Gehäusegrundkörper, die nicht für eine Strahlungsemission oder Strahlungstransmission vorgesehen sind, oft teildurchlässig für die elektromagnetische Strahlung sind. Insbesondere bei Gehäusen mit dünnen Gehäusewänden derartiger Gehäusegrundkörper werden diese von einem Teil der im Inneren des Gehäuses erzeugten elektromagnetischen Strahlung durchdrungen. Somit wird die elektromagnetische Strahlung nicht nur in einen bevorzugten Raumwinkel abgestrahlt.

Eine derartige in einen nicht bevorzugten oder gar unerwünschten Raumwinkel abgestrahlte elektromagnetische Strahlung ist für viele Anwendungen nicht störend, da sie lediglich einen geringen Anteil an der insgesamt aus dem Gehäuse emittierten Strahlungsintensität ausmacht. Es wurde jedoch festgestellt, dass sich die seitlich emittierte elektromagnetische Strahlung insbesondere bei Scheinwerfer- und Projektionsapplikationen als störend auswirken kann. Dies ist beispielsweise bei Applikationen der Fall, bei denen ein Strahlenkegel mit einer wohldefinierten Leuchtdichteverteilung und scharfen Hell/Dunkel-Übergängen erzielt werden soll.

Mit der Maßnahme, die Außenfläche mit einer Abschirmschicht zu versehen, wird ein technisch einfaches und effizientes Mittel angegeben, um die Abstrahlcharakteristik derartiger Gehäuse zu verbessern. Das Aufbringen der Abschirmschicht erfordert vorteilhafterweise grundsätzlich kein spezielles Gehäusedesign, sondern es kann bei vielen herkömmlichen Gehäusen durchgeführt werden. Bevorzugt weist die Außenfläche einen senkrecht zu einer optischen Achse des Gehäuses und/oder parallel zu der Chipmontagefläche verlaufenden Bereich auf.

In einer vorteilhaften Ausführungsform weist der Gehäusegrundkörper ein Trägerteil, auf dem die Chipmontagefläche angeordnet ist, und einen auf dem Trägerteil angeordneten Rahmenteil auf, der die Kavität definiert. Die Abschirmschicht kann hierbei insbesondere ausschließlich auf dem Rahmenteil angeordnet sein, so dass der Rahmenteil und die Abschirmschicht unabhängig vom übrigen Gehäuse gefertigt werden können, was die Fertigung signifikant vereinfachen kann.

Die Außenfläche grenzt bevorzugt an eine Innenwand der Ausnehmung, die als eine Blendenwand ausgebildet ist, die geeignet ist, eine Strahlungsemission aus dem Gehäuse in einen unerwünschten Raumbereich zu unterdrücken. Durch die Abschirmschicht kann eine weitergehende Unterdrückung oder vollständige Vermeidung von Strahlungsemission in diese unerwünschten Raumbereiche erzielt werden.

Die Blendenwand verläuft gemäß einer besonders bevorzugten Ausführungsform im wesentlichen in einem Winkel von größer als oder gleich 80° und kleiner als oder gleich 100° zu einer Haupterstreckungsebene der Chipmontagefläche. Sie ist bevorzugt eben ausgebildet, kann aber auch Krümmungen oder Strukturen aufweisen. Besonders bevorzugt verläuft die Blendenwand im Wesentlichen senkrecht zu der Haupterstreckungsebene der Chipmontagefläche.

Die Außenfläche kann teilweise oder vollständig eben ausgebildet sein. Es ist alternativ oder zusätzlich auch möglich, dass sie konkav oder konvex gekrümmt oder in irgendeiner Art strukturiert ist.

Die Abschirmschicht ist insbesondere dazu geeignet, eine elektromagnetische Strahlung abzuschirmen, die einen Spektralbereich einer von einem Lumineszenzdiodenchip emittierten elektromagnetischen Strahlung umfasst, wobei der Lumineszenzdiodenchip für ein Bauelement mit dem Gehäuse vorgesehen ist.

Besonders bevorzugt ist die Abschirmschicht geeignet, eine elektromagnetische Strahlung vollständig abzuschirmen, das heißt die Abschirmschicht ist besonders bevorzugt undurchlässig für eine elektromagnetische Strahlung eines abzuschirmenden Wellenlängenbereiches. Der abzuschirmende Wellenlängenbereich kann insbesondere der gesamte Wellenlängenbereich einer von einem Bauelement, das mit dem Gehäuse herzustellen ist, emittierten elektromagnetischen Strahlung sein. Es ist jedoch auch möglich, dass die Abschirmschicht auch teilweise durchlässig für elektromagnetische Strahlung ist. Beispielsweise kann sie für elektromagnetische Strahlung eines nicht notwendigerweise abzuschirmenden Wellenlängenbereiches oder auch für eine abzuschirmende elektromagnetische Strahlung teilweise durchlässig sein. Die abzuschirmende elektromagnetische Strahlung ist bevorzugt sichtbares Licht.

Bevorzugt weist die Abschirmschicht für einen abzuschirmenden Wellenlängenbereich einer elektromagnetischen Strahlung, die von einem Bauelement mit dem Gehäuse emittiert wird, einen Gesamttransmissionsgrad von kleiner als oder gleich 0,2, besonders bevorzugt von kleiner als oder gleich 0,1 auf. Mit besonderem Vorteil ist dieser Gesamttransmissionsgrad zumindest für den sichtbaren Anteil der Strahlung ungefähr 0.

Unter dem Begriff "Abschirmschicht" fallen vorliegend keine elektrischen Anschlussleiter oder elektrische Leiterbahnen des Gehäuses. Vielmehr ist das Gehäuse auf der Außenfläche entweder frei von elektrischen Leiterbahnen oder elektrischen Anschlussleitern oder das Gehäuse weist an der Außenfläche zusätzlich zu etwaigen vorhandenen elektrischen Anschlussleitern oder elektrischen Leiterbahnen mindestens eine Abschirmschicht auf.

Gemäß einer vorteilhaften Ausführungsform weist die Abschirmschicht ein für die elektromagnetische Strahlung reflektierendes Material auf. Dadurch kann die elektromagnetische Strahlung von der Außenfläche in den Gehäusekörper zurückreflektiert werden und ist somit nicht notwendigerweise für eine Nutzung verloren.

Zusätzlich oder alternativ weist die Abschirmschicht mit Vorteil ein für die elektromagnetische Strahlung absorbierendes Material auf. Geeignete absorbierende Materialien können mit Vorteil besonders kostengünstig sein und die elektromagnetische Strahlung mit hoher Effizienz abschirmen. Besonders bevorzugt umfasst das absorbierende Material ein schwarzes Material, das heißt die Farbe des Materials ist für das menschliche Auge als ein Schwarzton wahrnehmbar.

Gemäß einer zweckmäßigen Ausführungsform weist die Abschirmschicht einen Lack auf. Lacke sind kostengünstige Materialien, die sich auf technisch einfache Weise auftragen lassen.

Zweckmäßigerweise weist der Gehäusekörper im Bereich der Außenfläche keramisches Material und/oder Kunststoff auf. Kunststoffe und keramische Materialien, wie sie für herkömmliche optoelektronische Gehäuse verwendet werden, sind oftmals teilweise durchlässig für elektromagnetische Strahlung wie beispielsweise sichtbares Licht. Eine gedämpfte Strahlungsemission des Gehäusegrundkörpers kann im Rahmen der vorliegenden Erfindung genutzt werden, um eine wohldefinierte Abstrahlcharakteristik zu erzielen. Durch die Abschirmschicht wird die Strahlungsemission in Teilbereichen weitergehend gedämpft oder vollständig verhindert, was eine weitergehende Möglichkeit zum Formen der Abstrahlcharakteristik darstellt.

Eine weitere vorteilhafte Ausführungsform sieht vor, dass zusätzlich zumindest eine äußere Seitenfläche des Gehäusegrundkörpers, die an die Außenfläche angrenzt, mit einer Abschirmschicht versehen ist. Bevorzugt erstreckt sich eine gemeinsame Abschirmschicht sowohl über die Außenfläche als auch über die äußere Seitenfläche. Das Versehen der Außenfläche und der äußeren Seitenfläche erfolgt mit Vorteil im wesentlichen gleichzeitig.

Die äußere Seitenfläche des Gehäuses ist mit besonderem Vorteil gegenüber einer senkrecht zu einer Montageebene des Gehäuses verlaufenden Ebene zumindest teilweise geneigt. Die äußere Seitenfläche ist insbesondere derart geneigt, dass sie zumindest teilweise von der Montageebene des Gehäuses abgewandt ist. Dies kann für ein Aufbringen der Abschirmschicht vorteilhaft sein, da die geneigten Teile der äußeren Seitenfläche nicht senkrecht zu der Montageebene des Gehäuses verläuft und somit nicht nur seitlich, sondern auch von oben zugänglich ist. Unter einer Oberseite des Gehäuses ist vor allem eine von einer Montageebene des Gehäuses abgewandte Seite zu verstehen.

Besonders bevorzugt ist die äußere Seitenfläche gegenüber der senkrecht zu einer Montageebene des Gehäuses verlaufenden Ebene zumindest teilweise zwischen einschließlich 30° und einschließlich 60° geneigt.

Es wird weiterhin ein Gehäuse angegeben, bei dem die Abschirmschicht mit Vorteil Kunststoff aufweist oder aus Kunststoff besteht. Kunststoffe können mit Vorteil absorbierende Eigenschaften aufweisen und sich beispielsweise in Form einer Beschichtung aufbringen lassen.

Das elektromagnetische Strahlung emittierende optoelektronische Bauelement umfasst das Gehäuse und mindestens eine Lumineszenzdiode, beispielsweise in Form eines Lumineszenzdiodenchips, die in dem Gehäuse montiert ist.

Es wird ein Verfahren zum Herstellen eines Gehäuses für ein optoelektronisches Bauelement oder eines elektromagnetische Strahlung emittierenden Bauelements angegeben. Ein Verfahrensschritt umfasst das Bereitstellen eines Gehäuses oder eines Bauelements mit einem Gehäuse. Ein weiterer Verfahrensschritt beinhaltet das Aufbringen einer Abschirmschicht auf zumindest einen Teil von auf einer Abstrahlseite angeordneten Oberflächen des Gehäuses.

Mit Vorteil wird ein Gehäuse mit einem Gehäusegrundkörper, der eine Ausnehmung aufweist, bereitgestellt. Die Abschirmschicht wird auf zumindest eine Außenfläche, die auf einer Abstrahlseite des Gehäuses angeordnet ist und an die Ausnehmung angrenzt aufgebracht.

Besonders bevorzugt umfasst das Aufbringen der Abschirmschicht die Verwendung von Tampondruck. Der Tampondruck ist ein indirektes Druckverfahren, das insbesondere zum Bedrucken von Kunststoffkörpern geeignet ist. Mittels eines Tampondrucks lassen sich auch unebene, beispielsweise konvex oder konkav gewölbte Flächen mit einem aufzubringenden Material versehen.

Zusätzlich oder alternativ kann das Aufbringen der Abschirmschicht die Verwendung von mindestens einem der Methoden Siebdruck, Tintenstrahldruck, Kunststoffbeschichtung und Pulverbeschichtung umfassen.

Das Aufbringen der Abschirmschicht umfasst gemäß einer weiteren vorteilhaften Ausführungsform des Verfahrens das Aufbringen eines metallhaltigen Materials. Das Aufbringen dieses Materials kann im Dickschichtverfahren und/oder im Dünnschichtverfahren erfolgen. Ein Dickschichtverfahren umfasst bevorzugt das Aufbringen einer metallhaltigen Paste. Ein vorteilhaftes Dünnschichtverfahren umfasst das Aufsputtern von metallhaltigem Material. Alternativ lassen sich durch Aufsputtern oder Aufbringen einer Paste grundsätzlich auch metallfreie Materialien aufbringen.

Weitere Vorteile, bevorzugte Ausführungsformen und Weiterbildungen des Gehäuses, des Bauelements und des Verfahrens ergeben sich aus dem im Folgenden in Verbindung mit den Figuren 1 bis 13 erläuterten Ausführungsbeispielen.
Es zeigen:
- Figuren 1 bis 3: verschiedene schematische perspektivische Darstellungen eines Gehäuses gemäß eines ersten Ausführungsbeispiels,
- Figuren 4 und 5: verschiedene schematische perspektivische Darstellungen eines Gehäuses gemäß eines zweiten Ausführungsbeispiels,
- Figur 6: eine schematische perspektivische Darstellung eines Bauelements gemäß eines ersten Ausführungsbeispiels und eines Gehäuses gemäß eines dritten Ausführungsbeispiels,
- Figur 7: eine schematische perspektivische Darstellung eines Bauelements gemäß eines zweiten Ausführungsbeispiels und eines Gehäuses gemäß eines vierten Ausführungsbeispiels,
- Figur 8: eine schematische Schnittansicht eines Gehäuses gemäß eines fünften Ausführungsbeispiels und eines Bauelements gemäß eines dritten Ausführungsbeispiels,
- Figuren 9 bis 11: schematische Schnittansichten verschiedener Verfahrensstadien eines Ausführungsbeispiels des Verfahrens.

In den Ausführungsbeispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht notwendigerweise als maßstabsgerecht anzusehen. Vielmehr können einige Details der Figuren zum besseren Verständnis übertrüben groß dargestellt sein. Dies gilt insbesondere für die beispielhaften Darstellungen der Abschirmschicht.

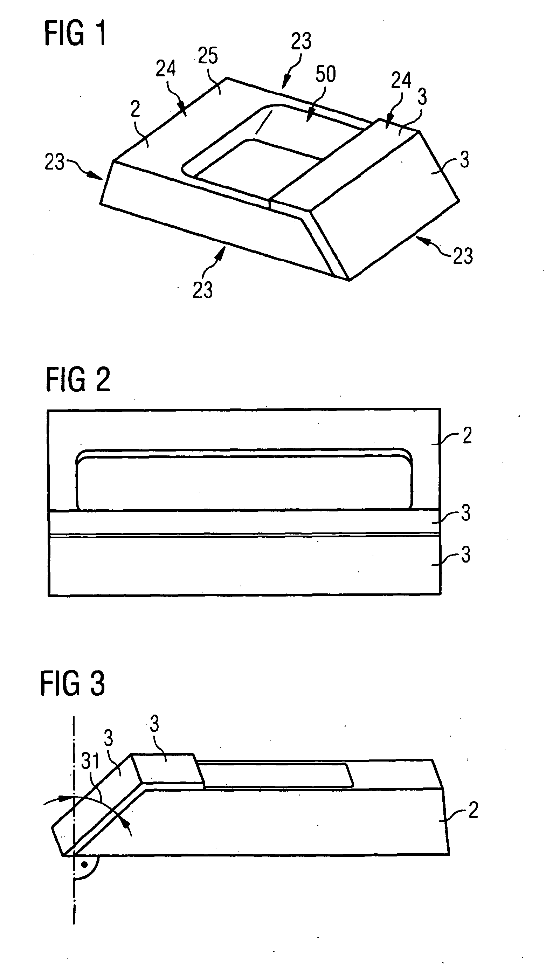

Das in den Figuren 1 bis 3 dargestellte Gehäuse 2 weist einen Gehäusekörper 25 mit einer Kavität 50 auf. Die Öffnung der Kavität 50 weist eine lang gestreckte Querschnittsfläche auf, die beispielsweise in der Art eines Rechteckes mit verrundeten Kanten ausgebildet ist. Die Kavität 50 ist dafür vorgesehen, in ihr mindestens einen Lumineszenzdiodenchip zu montieren und elektrisch leitend anzuschließen. Das in den Figuren 1 bis 3 dargestellte Gehäuse ist beispielsweise für vier oder fünf Lumineszenzdiodenchips vorgesehen, die an einem Boden der Kavität 50 zum Beispiel in einer linienförmigen Anordnung montiert werden.

Der Gehäusekörper 25 weist beispielsweise ein Kunststoffmaterial auf oder besteht aus einem solchen. Vorzugsweise wird hierfür ein thermoplastischer oder duroplastischer Kunststoff verwendet, beispielsweise Polyphtalamid. Dem Kunststoffmaterial können Füllstoffe zugesetzt sein. Geeignete Füllstoffe sind beispielsweise Bariumsulfat, Anatas (dies ist eine Modifikation von TiO₂) und Polytetrafluorethylen (PTFE, beispielsweise Teflon), die vorzugsweise mit einem Volumenanteil bis zu 50 % zugesetzt sind. Ein weiterhin bevorzugter Volumenanteil liegt im Bereich zwischen etwa 5 % und etwa 15 %.

Das Gehäuse 2 weist auf einer Abstrahlseite angeordnete Außenflächen 24 des Gehäusekörpers 25 auf, die sich senkrecht zu einer optischen Achse des Gehäuses oder parallel zu einer in der Ausnehmung 50 angeordneten Chipmontagefläche erstrecken. Eine dieser Außenflächen 24, die an eine von vier die Ausnehmung 50 begrenzenden Hauptkanten angrenzt, ist mit einer Abschirmschicht 3 versehen. Zudem weist der Gehäusekörper 4 äußere Seitenflächen 23 auf. Die Abschirmschicht 3 erstreckt sich auch über eine dieser äußeren Seitenflächen 23.

In dem in den Figuren 1 bis 3 dargestellten Ausführungsbeispiel bedeckt die Abschirmschicht 3 die eine äußere Seitenfläche 23 vollständig und reicht auf der vorderseitigen Außenfläche bi an die Ausnehmung 50 heran. Es ist jedoch auch möglich, dass diese Außenfläche und äußere Seitenfläche 23 nur teilweise von der Abschirmschicht 3 bedeckt sind. Ebenso ist es möglich, dass die Seitenflächen 23 frei von einer Abschirmschicht sind. Beispielsweise kann nur eine an die Ausnehmung 50 angrenzende Hälfte der Außenfläche 24, die in dem in Figur 1 dargestellten Ausführungsbeispiel vollständig mit der Abschirmschicht 3 bedeckt ist, mit der Abschirmschicht 3 versehen sein.

Die mit der Abschirmschicht 3 versehene äußere Seitenfläche 23 ist gegenüber einer senkrecht zu einer Montageebene des Gehäuses verlaufenden Ebene geneigt. Die Seitenfläche ist eben ausgebildet und gegenüber der Ebene um einen Winkel 31 gekippt, siehe Figur 3. Der Winkel 31 beträgt zwischen einschließlich 30° und einschließlich 60°, beispielsweise 40°.

Die Abschirmschicht 3 besteht beispielsweise aus einem reflektierenden Material, das zum Beispiel metallisches Material wie Silber aufweist. Zum Ausbilden der Abschirmschicht ist z.B. eine Silberschicht mit einer ausreichend hohen Schichtdicke auf den entsprechenden Flächen des Gehäuses aufgebracht. Silber weist für einen großen Spektralbereich sichtbaren Lichts eine hohe Reflektivität auf. Die Silberschicht kann lediglich wenige Monolagen dick sein, damit sie gezielt noch teilweise für elektromagnetische Strahlung durchlässig ist. Um eine vollständige Abschirmung zu erzielen, muss die Dicke signifikant größer sein. Hierzu weist sie beispielsweise eine Dicke von 10 µm auf.

Metallhaltige Schichten wie die Silberschicht lassen sich z.B. durch Aufbringen einer entsprechenden metallhaltigen Paste oder durch Aufsputtern auf vorteilhafte Weise aufbringen. Metallschichten können zusätzlich oder alternativ grundsätzlich auch aufgedampft werden.

Zusätzlich oder alternativ kann die Abschirmschicht 3 beispielsweise auch absorbierendes Material aufweisen. Hierfür kommt zum Beispiel ebenfalls metallisches Material in Frage, das für einen vorgesehenen Spektralbereich überwiegend absorbierende Eigenschaften aufweist. Auch bei dem absorbierenden Material ist es wichtig, dieses nicht in einer zu dünnen Schicht aufzutragen, wenn eine im Inneren des Gehäuses erzeugte elektromagnetische Strahlung weitestgehend abgeschirmt werden soll. Die Abschirmschicht weist für einen abzuschirmenden Wellenlängenbereich beispielsweise einen Gesamttransmissionsgrad von kleiner als oder gleich 0,05 auf. Als absorbierendes Material kommen beispielsweise auch Lacke oder Kunststoffe in Frage.

Die Abschirmschicht 3 weist gemäß einer weiteren beispielhaften Ausführungsform eine reflektierende Schicht auf, die auf der entsprechenden Außenfläche 24 und äußeren Seitenfläche 23 aufgebracht ist und auf der wiederum eine absorbierende Schicht aufgebracht ist. Die absorbierende Schicht ist beispielsweise ein schwarzer Lack oder ein schwarzer Kunststoff. Diese sind insbesondere für sichtbare elektromagnetische Strahlung absorbierend. Die Abschirmschicht 3 kann alternativ beispielsweise auch nur aus einer ausreichend dicken schwarzen Lackschicht oder schwarzen Kunststoffschicht bestehen.

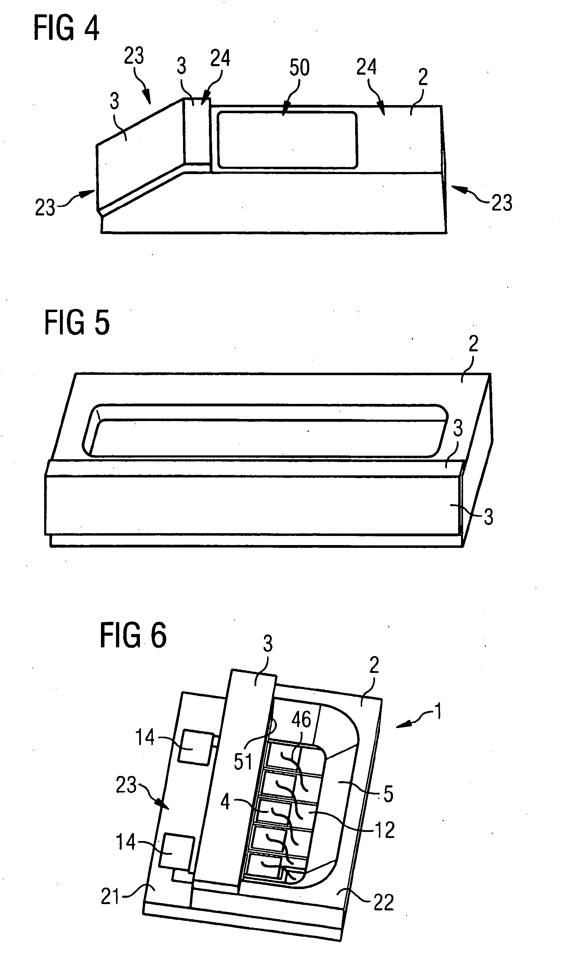

Bei dem in den Figuren 4 und 5 dargestellten Gehäuse 2 ist die Abschirmschicht 3 im Unterschied zu dem vorhergehend anhand der Figuren 1 bis 3 beschriebenen Gehäuse derart auf der abstrahlseitigen, an die Kavität 50 angrenzenden Außenfläche 24 aufgebracht, dass sie von der Kavität beabstandet ist. Mit anderen Worten bedeckt die Abschirmschicht 3 die an die Kavität angrenzende Außenfläche 24 nicht vollständig, sondern nur einen von der Kavität 50 beabstandeten Teil dieser Außenfläche. Dies kann vorteilhaft sein, wenn mit dem Gehäuse eine Abstrahlcharakteristik mit einer wohldefinierten Hell-Dunkel Grenze auf mindestens einer Seite des emittierten Strahlenkegels erzielt werden soll. Ein zu scharfer Verlauf einer solchen Hell-Dunkel Grenze kann abgeschwächt werden, indem die Abschirmschicht von der Kavität zurückgezogen wird.

Auch die an diese Außenfläche angrenzende äußere Seitenfläche 23 ist nur teilweise mit einer Abschirmschicht 3 bedeckt. Die teilweise mit der Abschirmschicht 3 bedeckte äußere Seitenfläche 23 weist einen ersten und einen zweiten Teil auf. Beide Teile sind beispielsweise eben ausgebildet. Der erste Teil verläuft zum Beispiel senkrecht gegenüber einer Montageebene des Gehäuses 2. Der zweite Teil ist gegenüber dem ersten Teil geneigt, beispielsweise um 55°. Dieser zweite Teil ist zum Beispiel vollständig mit der Abschirmschicht 3 bedeckt. Der erste Teil ist frei von der Abschirmschicht. Alternativ kann auch der erste Teil mit der Abschirmschicht bedeckt sein.

Im übrigen kann das in den Figuren 4 und 5 dargestellte Gehäuse 2 wie das vorhergehend anhand der Figuren 1 bis 3 dargestellte Gehäuse ausgebildet sein. Das gleiche gilt für mögliche Zusammensetzungen, Materialien und Aufbauten der Abschirmschicht 3.

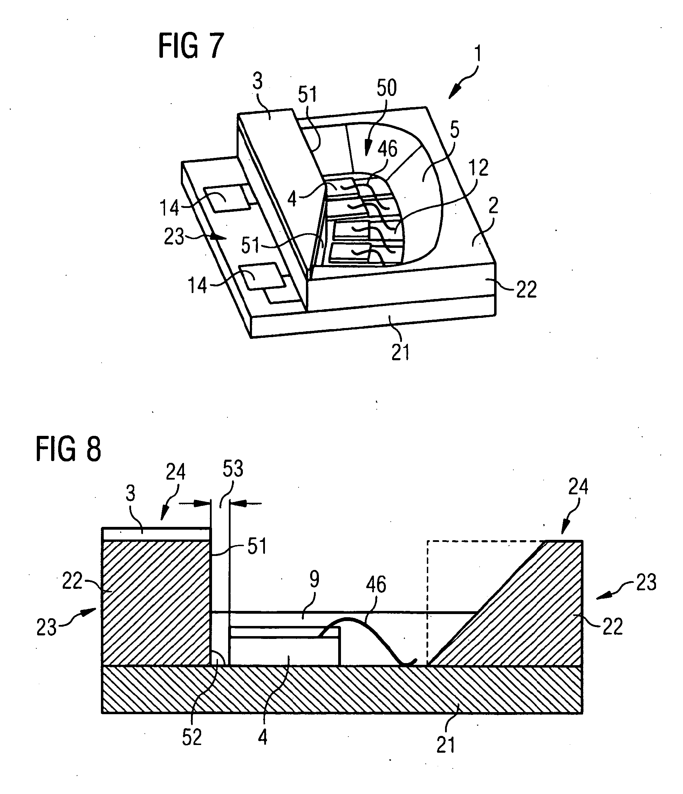

Die in den Figuren 6 und 7 dargestellten Bauelemente weisen ein Gehäuse 2 mit einem Träger 21 und einem auf dem Träger 21 angeordneten Rahmen 22 auf. Der Rahmen 22 weist Innenwände 5 auf, die eine Kavität 50 begrenzen. In der grabenartig ausgebildeten Kavität 50 ist eine Mehrzahl von Halbleiterchips 4 in einer linienförmigen Anordnung angeordnet.

Die Innenwände 5 der Kavität 50 weisen einen relativ geringen Abstand zu den Lumineszenzdiodenchips 4 auf. Der Abstand ist beispielsweise kleiner als oder gleich einer lateralen Kantenlänge der Lumineszenzdiodenchips 4. Entsprechend weist der Boden der Kavität 50 eine relativ geringe Fläche auf.

Die Lumineszenzdiodenchips 4 sind in dem Gehäuse 2 elektrisch montiert, wobei sie beispielsweise in Serie zueinander geschaltet sind. Hierzu weist der Boden der Kavität 50 eine Mehrzahl von inneren elektrischen Kontaktflächen 12 auf, wobei die Lumineszenzdiodenchips z.B. auf ihrer dem Boden 54 der Kavität 50 zugewandten Seite z.B. mittels Löten oder Leitkleber elektrisch leitend mit den entsprechenden inneren Kontaktflächen 12 verbunden sind und auf einem Teil der jeweiligen Kontaktfläche 12 aufliegen. Eine von den inneren Kontaktflächen 12 abgewandte Seite der Lumineszenzdiodenchips 4 ist z.B. mittels eines Bonddrahtes 46 mit der entsprechenden Kontaktfläche elektrisch leitend verbunden.

Zwei der inneren Kontaktflächen 12 erstrecken sich auf dem Träger 21 bis zu einem Bereich des Trägers 21, der lateral zu dem Rahmen 22 versetzt ist, wo sie elektrisch leitend mit Außenkontakten 14 des Bauelements 1 elektrisch leitend verbunden sind, über die das Bauelement 1 extern elektrisch angeschlossen werden kann.

Die Lumineszenzdiodenchips 4 emittieren bei ihrem Betrieb z.B. eine elektromagnetische Strahlung aus einem blauen oder ultravioletten Wellenlängenbereich.

Beispielsweise weist der Rahmen Aluminiumoxid auf oder besteht aus diesem. Alternativ ist es auch möglich, dass der Rahmen ein weniger gut reflektierendes Material, wie z.B.

Aluminiumnitrid oder ein Flüssigkristallpolymer (LCP), aufweist oder aus diesem besteht. Die Verwendung von LCP als ein Material für den Rahmen 22 hat den Vorteil, dass sich das Material thermisch an den Träger 21 anpassen lässt. Der Träger 21 weist als Material z.B. Aluminiumnitrid auf, welches kostengünstig ist und eine hohe Wärmeleitfähigkeit aufweist. Als alternative oder zusätzliche Materialien für den Träger sind beispielsweise auch Silizium oder Siliziumcarbid möglich.

Bei dem in Figur 6 dargestellten Bauelement sind die Lumineszenzdiodenchips 4 entlang einer Geraden angeordnet. Im Unterschied dazu sind die Lumineszenzdiodenchips 4 bei dem in Figur 7 dargestellten Bauelement teilweise entlang einer ersten Gerade und teilweise entlang einer zweiten Gerade angeordnet, wobei die erste und die zweite Gerade miteinander einen Winkel von beispielsweise 15° einschließen. Die Anordnung der Lumineszenzdiodenchips 4 weist somit einen Knick auf.

Das Gehäuse 2 der in den Figuren 6 und 7 dargestellten Bauelemente 1 weist auf einer Seite entlang der Anordnung der Lumineszenzdiodenchips 4 eine die Kavität 50 begrenzende Innenwand auf, wobei zumindest ein Abschnitt der Innenwand als eine Blendenwand 51 ausgebildet ist. Durch eine derartige Blendenwand kann die Emission der Strahlung in einen unerwünschten Raumbereich unterdrückt werden. Hierzu verläuft die Blendenwand 51 zweckmäßigerweise im wesentlichen in einem Winkel von größer als oder gleich 80° und kleiner als oder gleich 110° zu einer Montageebene der Lumineszenzdiodenchips 4. Insbesondere verläuft die Blendenwand im wesentlichen senkrecht zu der Montageebene.

In lateraler Richtung entspricht der Verlauf der Blendenwand der Anordnung der Lumineszenzdiodenchips. Ebenso kann man sagen, dass die Lumineszenzdiodenchips entlang der Blendenwand 51 angeordnet sind. Insbesondere weist die Blendenwand 51 bei dem in Figur 7 dargestellten Ausführungsbeispiel in ihrem lateralen Verlauf einen Knick auf, wie die Anordnung der Lumineszenzdiodenchips. Gleiches gilt für eine an der Öffnungsseite der Kavität angeordnete Kante der Blendenwand 50. Unter einer lateralen Richtung ist eine Richtung zu verstehen, die sich parallel zu einer Montageebene erstreckt.

In Figur 8 ist ein Querschnitts eines Bauelements dargestellt, das im wesentlichen in der Art der vorhergehend anhand der Figuren 6 und 7 erläuteten Bauelemente ausgebildet sein kann. Die der Blendenwand 51 gegenüberliegende Innenwand der Kavität ist als eine Reflektorwand ausgebildet, die sich schräg zur Haupterstreckungsebene des Trägers 21 erstreckt. Sie ist beispielsweise um 45° gegenüber der Haupterstreckungsebene des Trägers geneigt. Alternativ kann auch diese Wand als eine Blendenwand ausgebildet sein, die wie die Blendenwand 51 beschaffen sein kann. Eine Beispielhafte Querschnittsform ist in Figur 8 mit gestrichelten Linien angedeutet.

Die Lumineszenzdiodenchips 4 sind in einem Abstand 53 von beispielsweise kleiner als oder gleich 500 µm, bevorzugt von kleiner als oder gleich 150 µm zu der Blendenwand 51 angeordnet. Alternativ kann der Lumineszenzdiodenchip zur Randkante der Blendenwand 51, die auf der Öffnungsseite der Kavität angeordnet ist, unabhängig vom Verlauf der übrigen Blendenwand einen lateralen Abstand von kleiner als oder gleich 500 µm, bevorzugt von kleiner als oder gleich 150 µm zu den Lumineszenzdiodenchips 4 aufweisen, um eine effektive Blendenwirkung zu erzielen. Der laterale Abstand wird in diesem Fall in der Ebene gemessen, in der die Lumineszenzdiodenchips montiert sind.

Bei einem derart geringen Abstand 53 kann eine effektive Blendenwirkung der Blendenwand 51 auch dann erreicht werden, wenn die Blendenwand 51 relativ niedrig ausgebildet ist, d.h. wenn sie eine geringe Höhe aufweist. Zudem trifft durch diesen geringen Abstand ein Teil der von den Lumineszenzdiodenchips 4 emittierten elektromagnetischen Strahlung mit einer hohen Strahlungsintensität pro Fläche auf die Blendenwand 51, wodurch sowohl die Vermeidung von Strahlung in einem unerwünschten Raumwinkel als auch das Abstrahlen der elektromagnetischen Strahlung in einen gewünschten, bevorzugt engen Raumwinkel und mit einer hohen Strahlungsdichte weitgehend ermöglicht wird.

Diese Eigenschaften sind insbesondere bei Scheinwerfern, beispielsweise bei Autoscheinwerfern erwünscht, durch die ein bestimmter Raumwinkel möglichst hell ausgeleuchtet werden soll. Bei Autoscheinwerfern soll beispielsweise einerseits der Fahrtweg, d.h. insbesondere die Straße möglichst hell ausgeleuchtet werden, andererseits dürfen jedoch entgegenkommende Fahrzeuge nicht geblendet werden, so dass eine Abstrahlung von Licht in den oberen Raumwinkel unerwünscht und weitestgehend vermeiden ist. Eben dies kann durch ein Bauelement mit einer Blendenwand 51 erreicht werden. Zudem ermöglicht die gestreckte Anordnung der Lumineszenzdiodenchips 4 eine helle und flächige, homogene Ausleuchtung des Weges bzw. der Straße über die gesamte Breite der Straße hinweg.

Diejenige Außenfläche 24 des Rahmens 21, die an die Blendenwand 51 angrenzt, ist bei den in den Figuren 6 bis 8 dargestellten Bauelementen 1 jeweils mit einer Abschirmschicht 3 versehen. Diese kann wie vorhergehend bereits beschrieben ausgebildet sein. Durch die Abschirmschicht 3 ist eine Vermeidung von Strahlungsemission in einen unerwünschten Raumwinkel weitergehend realisierbar.

Die beschriebenen Gehäuse 2 und Bauelemente 1 können insbesondere für ein Scheinwerfermodul, insbesondere auch für Automobilanwendungen, verwendet werden. Ebenso können sie für Projektionsanwendungen geeignet sein.

Die Bauelemente 1 emittieren zum Beispiel weißes Licht, wofür sie beispielsweise ein Lumineszenzkonversionselement aufweisen, das die von den Lumineszenzdiodenchips 4 emittierte Strahlung eines ersten Wellenlängenbereiches zumindest teilweise in eine Strahlung eines zweiten, von dem ersten Wellenlängenbereich unterschiedlichen Wellenlängenbereiches konvertiert. Weißes Licht kann entweder erzeugt werden, indem die von dem Lumineszenzdiodenchip emittierte Strahlung mit der konvertierten Strahlung gemischt wird oder indem die konvertierte Strahlung Farbanteile aufweist, die zusammengemischt weißes Licht ergeben.

Das Lumineszenzkonversionsmaterial kann mindestens einen Leuchtstoff enthalten. Es eignen sich grundsätzlich alle für die Anwendung bei LEDs bekannten Konverter. Beispiele für derartige als Konverter geeignete Leuchtstoffe und Leuchtstoffmischungen sind:
- Chlorosilikate, wie beispielsweise in DE 10036940 und dem dort beschriebenen Stand der Technik offenbart,
- Orthosilikate, Sulfide, Thiometalle und Vanadate wie beispielsweise in WO 2000/33390 und dem dort beschriebenen Stand der Technik offenbart,
- Aluminate, Oxide, Halophosphate, wie beispielsweise in US 6616862 und dem dort beschriebenen Stand der Technik offenbart,
- Nitride, Sione und Sialone wie beispielsweise in DE 10147040 und dem dort beschriebenen Stand der Technik offenbart, und
- Granate der Seltenen Erden wie YAG:Ce und der Erdalkalielemente wie beispielsweise in US 2004-062699 und dem dort beschriebenen Stand der Technik offenbart.

Die Lumineszenzdiodenchips 4 können entweder mit einer Vergussmasse 9 vergossen sein, wie in Figur 8 dargestellt, die beispielsweise auf Silikon basiert, oder mit einer strahlungsdurchlässigen Abdeckplatte abgedeckt sein, wodurch sie vor äußeren Einflüssen geschützt sind, was in den Figuren nicht dargestellt ist.

Durch den Aufbau des Gehäuses 2 mit einem Träger 21 und einem Rahmen 22 sowie mit auf dem Träger 21 aufgebrachten Kontaktflächen 12, 14 ist eine einfache Herstellung des Bauelements 1 möglich, bei der z.B. ein aufwendiges Erzeugen von Durchkontaktierungen nicht erforderlich ist. Alternativ kann der Gehäusekörper jedoch auch einstückig ausgebildet sein, beispielsweise durch Umspritzen eines Leadframes, das die jeweiligen Kontakte für die Lumineszenzdiodenchips 4 und das Bauelement 1 umfasst.

Die Lumineszenzdiodenchips 4 sind beispielsweise Leuchtdiodenchips, bevorzugt sind es Dünnfilm-Leuchtdiodenchips.

Ein Dünnfilm-Leuchtdiodenchip zeichnet sich insbesondere durch folgende charakteristische Merkmale aus:
an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
die Epitaxieschichtenfolge weist eine Dicke im Bereich von 20µm oder weniger, insbesondere im Bereich von 10 µm auf; und
die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben.

Ein Dünnfilm-Leuchtdiodenchip ist in guter Näherung ein Lambert'scher Oberflächenstrahler und eignet sich von daher besonders gut für die Anwendung in dem Bauelement, insbesondere für einen Scheinwerfer.

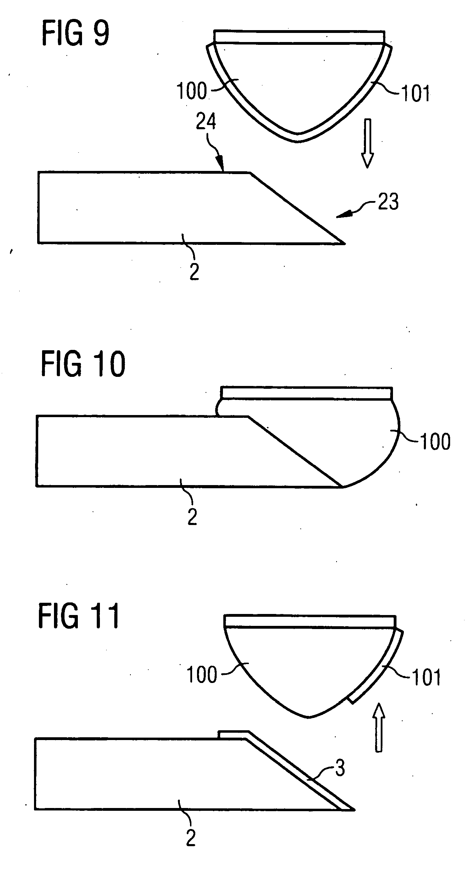

Bei den vorhergehend beschriebenen Ausführungsbeispielen kann zumindest ein Teil der Abschirmschicht 3 oder die gesamte Abschirmschicht 3 mittels Tampondruck aufgebracht werden. Verschiedene Verfahrensstadien eines beispielhaften derartigen Verfahrens sind in den Figuren 9 bis 11 dargestellt.

Ein Tampon 100 wird mit einem Abschirmmaterial 101 versehen. Hierzu wird der Tampon beispielsweise auf eine Vorrichtung, auf der das Abschirmmaterial aufgebracht ist, aufgedrückt. Derartige Vorrichtungen nennt man Druckstock oder Klischee. Der Tampon 100 besteht aus einem hochelastischen Material, das beispielsweise einen Kautschuk aufweist oder aus einem solchen besteht. Besonders geeignet ist Silikonkautschuk.

In Figur 11 ist ein Tampon 100 dargestellt, der mit einem Abschirmmaterial 101 wie beispielsweise schwarzer Farbe benetzt ist. Der Tampon 100 wird nach unten auf das Gehäuse 2 geführt, so dass er auf eine abstrahlseitig angeordnete Außenfläche 24 und eine schräg verlaufende äußere Seitenfläche 23 des Gehäuses 2 auftrifft. Die Bewegungsrichtung des Tampons 100, die in Figur 11 durch einen Pfeil angeordnet ist, verläuft senkrecht zu einer Montageebene des Gehäuses 2. Die zu bedruckende äußere Seitenfläche 23 ist um einen Winkel von kleiner als 90°, beispielsweise 45°, gegenüber der Richtung geneigt, entlang der der Tampon 100 auf das Gehäuse 2 geführt wird.

Wenn der Tampon 100 gegen das Gehäuse 2 gedrückt wird, verformt er sich und passt sich der Außenform des Gehäuses an, so dass die sich senkrecht zur Bewegungsrichtung des Tampons erstreckende Außenfläche 24 sowie die schräg verlaufende äußeren Seitenfläche 23 in einem Verfahrensschritt gleichzeitig bedruckt werden können, siehe Figur 12.

Nachfolgend wird der Tampon 100 wieder vom Gehäuse 2 weggeführt, was in Figur 13 wiederum durch einen Pfeil angedeutet ist. Dasjenige Abschirmmaterial, das beim Aufdrücken des Tampons mit dem Gehäuse 2 in Berührung kommt, bleibt an diesem haften und bildet zumindest einen Teil einer Abschirmschicht 3, siehe Figur 13.

Diese Verfahrensschritte können je nach Bedarf beliebig oft wiederholt werden. Es können mittels derartigen Verfahrensschritten auch beispielsweise nacheinander unterschiedliche Abschirmmaterialien auf entsprechenden Flächen des Gehäuses 2 aufgebracht werden.

Alternativ oder zusätzlich zum Tampon-Druck kann die Abschirmschicht auch zumindest teilweise mittels Siebdruck aufgebracht werden. Hierzu wird z.B. ein Sieb oder eine Maske auf die entsprechenden Flächen des Gehäuses aufgebracht, auf das nachfolgend ein Abschirmmaterial aufgetragen wird. Das Abschirmmaterial weist eine für Siebdruck geeignete Viskosität auf. Es kann z.B. einen schwarzen Lack oder sonstige schwarze Farbe umfassen. Mittels einer Rakel wird das Abschirmmaterial in Aussparungen des Siebes oder der Maske auf den vorgesehenen Gehäuseflächen verteilt.

Als weiteres alternatives oder ergänzendes Verfahren ist z.B. auch Tintenstrahldruck zum Aufbringen von Abschirmmaterial geeignet. Insbesondere absorbierende Farbe, z.B. schwarze Farbe kann auf diese Weise aufgebracht werden. Hierzu wird z.B. ein herkömmlicher CIJ-Drucker ("Continous Ink Jet"-Drucker) verwendet. Die Verwendung eine DOD-Druckers ("Drop on demand"-Drucker) ist ebenso möglich.

Insbesondere Metallschichten können zusätzlich oder alternativ zu den vorhergehend beschriebenen Verfahren beispielsweise mittels Aufdampfen, Aufsputtern oder Aufkleben sowie durch Aufbringen einer Paste aufgebracht werden.

Weiterhin ist z.B. auch Kunststoffbeschichtung zum Aufbringen von Abschirmmaterial geeignet.

Sowohl Metallschichten als auch Kunststoffschichten lassen sich zusätzlich oder alternativ auch beispielsweise mittels Pulver-Beschichtung aufbringen. Es kann z.B. eine elektrostatische Pulverbeschichtung oder eine andersartige Pulverbeschichtung verwendet werden. Das Abschirmmaterial wird hierbei in Form eines Pulvers aufgetragen. Dieses wird nachfolgend erhitzt, wodurch es sich zu einer beispielsweise einstückigen Schicht verbindet und an der Oberfläche, auf die es aufgetragen wurde, haften bleibt.

Die Erfindung ist nicht durch die Beschreibung der Erfindung anhand der Ausführungsbeispiele auf diese beschränkt.

## Patentansprüche

1. Elektromagnetische Strahlung emittierendes optoelektronisches Bauelement, mit mindestens einer Lumineszenzdiode und einem Gehäuse, das einen Gehäusegrundkörper (25) mit einer Ausnehmung (50), in der mindestens eine Chipmontagefläche angeordnet ist, auf der die Lumineszenzdiode montiert ist, aufweist, wobei der Gehäusegrundkörper mehrere Außenflächen (24) aufweist, die auf einer Abstrahlseite des Gehäuses angeordnet sind und an die Ausnehmung angrenzen,
**dadurch gekennzeichnet, dass**
zumindest eine der Außenflächen zumindest teilweise mit einer Abschirmschicht (3) versehen ist, die geeignet ist, die eimittierte elektromagnetische Strahlung abzuschirmen, und dass die übrigen Außenflächen frei von der Abschirmschicht sind, wobei die Abschirmschicht keine elektrischen Anschlussleiter oder elektrische Leiterbahnen des Gehäuses bildet.

2. Bauelement nach Anspruch 1,
**dadurch gekennzeichnet,**
**dass** die Ausnehmung durch vier Hauptkanten begrenzt ist und die mit der Abschirmschicht versehene Außenfläche an eine dieser Hauptkanten angrenzt.

3. Bauelement nach einem der vorhergehenden Ansprüche,
**dadurch gekennzeichnet,**
**dass** die Außenfläche einen senkrecht zu einer optischen Achse des Gehäuses und/oder parallel zu der Chipmontagefläche verlaufenden Bereich aufweist.

4. Bauelement nach einem der vorhergehenden Ansprüche,
**dadurch gekennzeichnet,**
**dass** der Gehäusegrundkörper ein Trägerteil, auf dem die Chipmontagefläche angeordnet ist, und einen auf dem Trägerteil angeordneten Rahmenteil aufweist, der die Kavität definiert.

5. Bauelement nach einem der vorhergehenden Ansprüche,
**dadurch gekennzeichnet,**
**dass** die Außenfläche an eine Innenwand der Ausnehmung grenzt, die als eine Blendenwand ausgebildet ist, die geeignet ist, eine Strahlungsemission aus dem Gehäuse in einen unerwünschten Raumbereich zu unterdrücken.

6. Bauelement nach Anspruch 5,
**dadurch gekennzeichnet,**
**dass** die Blendenwand im wesentlichen in einem Winkel von größer als oder gleich 80° und kleiner als oder gleich 100° zu einer Haupterstreckungsebene der Chipmöntagefläche verläuft.

7. Bauelement nach Anspruch 5 oder 6,
**dadurch gekennzeichnet, dass**
die mit der Abschirmschicht versehene Außenfläche an die Blendenwand angrenzt.

8. Bauelement nach einem der vorhergehenden Ansprüche,
**dadurch gekennzeichnet,**
**dass** die Abschirmschicht ein für die elektromagnetische Strahlung reflektierendes Material aufweist.

9. Bauelement nach einem der vorhergehenden Ansprüche,
**dadurch gekennzeichnet, dass**
die Abschirmschicht ein für die elektromagnetische Strahlung absorbierendes Material aufweist.

10. Bauelement nach Ansprüch 9,
**dadurch gekennzeichnet, dass**
die Abschirmschicht ein schwarzes Material aufweist.

11. Bauelement nach einem der vorhergehenden Ansprüche,
**dadurch gekennzeichnet, dass**
die Abschirmschicht einen Lack aufweist.

12. Bauelement nach einem der vorhergehenden Ansprüche,
**dadurch gekennzeichnet, dass**
der Gehäusegrundkörper in einem Bereich, der mit der Abschirmschicht bedeckt ist, keramisches Material aufweist.

13. Bauelement nach einem der vorhergehenden Ansprüche,
**dadurch gekennzeichnet, dass**
der Gehäusegrundkörper in einem Bereich, der mit der Abschirmschicht bedeckt ist, Kunststoff aufweist.

14. Bauelement nach einem der vorhergehenden Ansprüche,
**dadurch gekennzeichnet, dass**
zusätzlich zumindest eine äußere Seitenfläche des Gehäusegrundkörpers, die an die Außenfläche angrenzt, mit einer Abschirmschicht versehen ist.

15. Bauelement nach Anspruch 14,
**dadurch gekennzeichnet, dass**
die äußere Seitenfläche gegenüber einer senkrecht zu einer Montageebene des Gehäuses verlaufenden Ebene zumindest teilweise geneigt ist.

16. Bauelement nach Anspruch 15,
**dadurch gekennzeichnet, dass**,
die äußere Seitenfläche gegenüber der Ebene zumindest teilweise zwischen einschließlich 30° und einschließlich 60° geneigt ist.

17. Bauelement nach einem der vorhergehenden Ansprüche,
**dadurch gekennzeichnet, dass**
die Abschirmschicht Kunststoff aufweist oder aus Kunststoff besteht.

18. Bauelement nach Anspruch einem der vorhergehenden Ansprüche,
**dadurch gekennzeichnet, dass**
es als ein Leuchtmodul für Fahrzeugscheinwerfer ausgebildet ist.

19. Verfahren zum Herstellen eines elektromagnetische Strahlung emittierenden Bauelements mit einem Gehäuse, **gekennzeichnet durch** die Verfahrensschritte:
- Bereitstellen eines Gehäuses mit einem Gehäusegrundkörper (25), der eine Ausnehmung (50) und mehrere Außenflächen (24) aufweist, die auf einer Abstrahlseite des Gehäuses angeordnet sind und an die Ausnehmung angrenzen;
- Aufbringen einer Abschirmschicht (3) auf zumindest eine der Außenflächen, wobei die Abschirmschicht geeignet ist, die emittierte elektromagnetische Strahlung abzuschirmen, und die übrigen Außenflächen von der Abschirmschicht frei bleiben, wobei die Abschirmschicht keine elektrischen Anschlussleiter oder elektrische Leiterbahnen des Gehäuses bildet.

20. Verfahren nach Anspruch 19,
**dadurch gekennzeichnet, dass**
das Aufbringen der Abschirmschicht die Verwendung von Tampondruck umfasst.

21. Verfahren nach Anspruch 19 oder 20,
**dadurch gekennzeichnet, dass**
das Aufbringen der Abschirmschicht die Verwendung von Siebdruck umfasst.

22. Verfahren nach einem der Ansprüche 19 bis 21,
**dadurch gekennzeichnet, dass**
das Aufbringen der Abschirmschicht die Verwendung von Tintenstrahldruck umfasst.

23. Verfahren nach einem der Ansprüche 19 bis 22,
**dadurch gekennzeichnet, dass**
das Aufbringen der Abschirmschicht die Verwendung von Kunststoffbeschichtung umfasst.

24. Verfahren nach einem der Ansprüche 19 bis 23,
**dadurch gekennzeichnet, dass**
das Aufbringen der Abschirmschicht die Verwendung von Pulverbeschichtung umfasst.

25. Verfahren nach einem der Ansprüche 19 bis 24,
**dadurch gekennzeichnet, dass**
das Aufbringen der Abschirmschicht das Aufbringen einer Paste und/oder Aufsputtern umfasst.

26. Verfahren nach Anspruch 25,
**dadurch gekennzeichnet, dass**
das Aufbringen der Abschirmschicht das Aufbringen eines metallhaltigen Materials mittels Aufbringen einer Paste und/oder Aufsputtern umfasst.

## Claims

1. Electromagnetic-radiation-emitting optoelectronic component, comprising at least one luminescence diode and a housing, which has a housing basic body (25) with a cutout (50), in which is arranged at least one chip mounting area on which the luminescence diode is mounted, wherein the housing basic body has a plurality of outer areas (24) which are arranged on an emission side of the housing and adjoin the cutout,
**characterized in that**
at least one of the outer areas is at least partly provided with a screening layer (3), which is suitable for screening the emitted electromagnetic radiation, and **in that** the remaining outer areas are free of the screening layer, wherein the screening layer forms no electrical connection conductors or electrical conductor tracks of the housing.

2. Component according to Claim 1,
**characterized**
**in that** the cutout is bounded by four main edges and the outer area provided with the screening layer adjoins one of said main edges.

3. Component according to either of the preceding claims,
**characterized**
**in that** the outer area has a region running perpendicular to an optical axis of the housing and/or parallel to the chip mounting area.

4. Component according to any of the preceding claims,
**characterized**
**in that** the housing basic body has a carrier part, on which the chip mounting area is arranged, and has a frame part arranged on the carrier part, said frame part defining the cavity.

5. Component according to any of the preceding claims,
**characterized**
**in that** the outer area adjoins an inner wall of the cutout, which is embodied as a diaphragm wall suitable for suppressing emission of radiation from the housing into an undesired spatial region.

6. Component according to Claim 5,
**characterized**
**in that** the diaphragm wall runs substantially at an angle of greater than or equal to 80° and less than or equal to 100° with respect to a main extension plane of the chip mounting area.

7. Component according to Claim 5 or 6,
**characterized**
**in that** the outer area provided with the screening layer adjoins the diaphragm wall.

8. Component according to any of the preceding claims,
**characterized**
**in that** the screening layer comprises a material that is reflective for the electromagnetic radiation.

9. Component according to any of the preceding claims,
**characterized**
**in that** the screening layer comprises a material that is absorbent for the electromagnetic radiation.

10. Component according to Claim 9,
**characterized in that**
the screening layer comprises a black material.

11. Component according to any of the preceding claims,
**characterized in that**
the screening layer comprises a lacquer.

12. Component according to any of the preceding claims,
**characterized in that**
the housing basic body comprises ceramic material in a region covered with the screening layer.

13. Component according to any of the preceding claims,
**characterized in that**
the housing basic body comprises plastic material in a region covered with the screening layer.

14. Component according to any of the preceding claims,
**characterized in that**
additionally at least one exterior side area of the housing basic body which adjoins the outer area is provided with a screening layer.

15. Component according to Claim 14,
**characterized in that**
the exterior side area is at least partly inclined with respect to a plane running perpendicular to a mounting plane of the housing.

16. Component according to Claim 15,
**characterized in that**
the exterior side area is inclined relative to the plane at least partly between 30° and 60° inclusive.

17. Component according to any of the preceding claims,
**characterized in that**
the screening layer comprises plastic or consists of plastic.

18. Component according to any of the preceding claims,
**characterized in that**
it is embodied as a luminous module for vehicle headlights.

19. Method for producing an electromagnetic-radiation-emitting component comprising a housing, **characterized by** the following method steps:
- providing a housing comprising a housing basic body (25), which has a cutout (50) and a plurality of outer areas (24) which are arranged on an emission side of the housing and adjoin the cutout;
- applying a screening layer (3) to at least one of the outer areas, wherein the screening layer is suitable for screening the emitted electromagnetic radiation, and the remaining outer areas remain free of the screening layer, wherein the screening layer forms no electrical connection conductors or electrical conductor tracks of the housing.

20. Method according to Claim 19,
**characterized in that**
applying the screening layer comprises the use of pad printing.

21. Method according to Claim 19 or 20,
**characterized in that**
applying the screening layer comprises the use of screen printing.

22. Method according to any of Claims 19 to 21,
**characterized in that**
applying the screening layer comprises the use of inkjet printing.

23. Method according to any of Claims 19 to 22,
**characterized in that**
applying the screening layer comprises the use of plastic coating.

24. Method according to any of Claims 19 to 23,
**characterized in that**
applying the screening layer comprises the use of powder coating.

25. Method according to any of Claims 19 to 24,
**characterized in that**
applying the screening layer comprises applying a paste and/or sputtering.

26. Method according to Claim 25,
**characterized in that**
applying the screening layer comprises applying a metal-containing material by means of applying a paste and/or sputtering.

## Revendications

1. Composant optoélectronique émettant un rayonnement électromagnétique et présentant au moins une diode luminescente et un boîtier qui présente un corps de base (25) de boîtier et une découpe (50) dans laquelle est disposée au moins une surface de montage de puce sur laquelle la diode luminescente est montée, le corps de base de boîtier présentant plusieurs surfaces extérieures (24) disposées sur le côté du boîtier par lequel le rayonnement est émis et adjacentes à la découpe,
**caractérisé en ce que**
au moins une partie d'au moins l'une des surfaces extérieures est dotée d'une couche de blindage (3) qui permet de bloquer le rayonnement électromagnétique émis et
**en ce que** les autres surfaces extérieures ne présentent pas de couche de blindage, la couche de blindage ne formant pas de conducteur de raccordement électrique ou de piste électriquement conductrice du boîtier.

2. Composant selon la revendication 1,
**caractérisé en ce que**
la découpe est délimitée par quatre arêtes principales et la surface extérieure dotée de la couche de blindage est adjacente à l'une de ces arêtes principales.

3. Composant selon l'une des revendications précédentes, **caractérisé en ce que** la surface extérieure présente une partie qui s'étend perpendiculairement à un axe optique du boîtier et/ou parallèlement à la surface de montage de puce.

4. Composant selon l'une des revendications précédentes, **caractérisé en ce que** le corps de base du boîtier présente une partie de support sur laquelle est disposée la surface de montage et une partie d'encadrement qui définit la cavité et qui est disposée sur la partie de support.

5. Composant selon l'une des revendications précédentes, **caractérisé en ce que** la surface extérieure est adjacente à une paroi intérieure de la découpe, configurée comme paroi d'écran, qui permet de diminuer l'émission du rayonnement hors du boîtier dans une zone spatiale indésirable.

6. Composant selon la revendication 5, **caractérisé en ce que** la paroi d'écran s'étend essentiellement sous un angle supérieur ou égal à 80° et inférieur ou égal à 100° par rapport au plan d'extension principal de la surface de montage de puce.

7. Composant selon les revendications 5 ou 6, **caractérisé en ce que** la surface extérieure dotée de la couche de blindage est adjacente à la paroi d'écran.

8. Composant selon l'une des revendications précédentes, **caractérisé en ce que** la couche de blindage présente un matériau qui réfléchit le rayonnement électromagnétique.

9. Composant selon l'une des revendications précédentes, **caractérisé en ce que** la couche de blindage présente un matériau qui absorbe le rayonnement électromagnétique.

10. Composant selon la revendication 9, **caractérisé en ce que** la couche de blindage présente un matériau noir.

11. Composant selon l'une des revendications précédentes, **caractérisé en ce que** la couche de blindage présente une peinture.

12. Composant selon l'une des revendications précédentes, **caractérisé en ce que** dans une partie recouverte par la couche de blindage, le corps de base du boîtier présente un matériau céramique.

13. Composant selon l'une des revendications précédentes, **caractérisé en ce que** dans sa partie recouverte par la couche de blindage, le corps de base du boîtier présente une matière synthétique.

14. Composant selon l'une des revendications précédentes, **caractérisé en ce que** de plus au moins une surface latérale extérieure du corps de base du boîtier, adjacente à la surface extérieure, est dotée d'une couche de blindage.

15. Composant selon la revendication 14, **caractérisé en ce qu'**au moins une partie de la surface latérale extérieure est inclinée par rapport à un plan qui s'étend perpendiculairement à un plan de montage du boîtier.

16. Composant selon la revendication 15, **caractérisé en ce qu'**au moins une partie de la surface latérale extérieure est inclinée entre 30° inclus et 60° inclus par rapport au plan.

17. Composant selon l'une des revendications précédentes, **caractérisé en ce que** la couche de blindage présente une matière synthétique ou est constituée de matière synthétique.

18. Composant selon l'une des revendications précédentes, **caractérisé en ce qu'**il est configuré comme module d'éclairage pour phare de véhicule.

19. Procédé de fabrication d'un composant émettant un rayonnement électromagnétique et doté d'un boîtier, **caractérisé par** les étapes qui consistent à :
prévoir un boîtier doté d'un corps de base (25) de boîtier qui présente une découpe (50) et plusieurs surfaces extérieures (24) disposées sur le côté du boîtier par lequel le rayonnement est émis et adjacentes à la découpe,
appliquer une couche de blindage (3) sur au moins l'une des surfaces extérieures, la couche de blindage permettant de bloquer le rayonnement électromagnétique émis, les autres surfaces extérieures ne présentant pas de couche de blindage, la couche de blindage ne formant pas de conducteur de raccordement électrique ou de piste électriquement conductrice du boîtier.

20. Procédé selon la revendication 19, **caractérisé en ce que** l'application de la couche de blindage comprend le recours à une impression au tampon.

21. Procédé selon les revendications 19 ou 20, **caractérisé en ce que** l'application de la couche de blindage comprend le recourt à la sérigraphie.

22. Procédé selon l'une des revendications 19 à 21, **caractérisé en ce que** l'application de la couche de blindage recourt à l'utilisation d'une impression par jet d'encre.

23. Procédé selon l'une des revendications 19 à 22, **caractérisé en ce que** l'application de la couche de blindage recourt à un revêtement de matière synthétique.

24. Procédé selon l'une des revendications 19 à 23, **caractérisé en ce que** l'application de la couche de blindage recourt à un revêtement de poudre.

25. Procédé selon l'une des revendications 19 à 24, **caractérisé en ce que** l'application de la couche de blindage comprend l'application d'une pâte et/ou une pulvérisation.

26. Procédé selon la revendication 25, **caractérisé en ce que** l'application de la couche de blindage comprend l'application d'un matériau contenant un métal par application d'une pâte et/ou pulvérisation.
